Europäisches Patentamt

European Patent Office

Office européen des brevets

(19)

(11) Veröffentlichungsnummer: **0 129 761 B1**

## (12) EUROPÄISCHE PATENTSCHRIFT

(45) Veröffentlichungstag der Patentschrift:
07.01.87

(21) Anmeldenummer: 84106635.0

(22) Anmeldetag: 09.06.84

(51) Int. Cl.⁴: **H 03 K 4/83**, H 04 N 3/16

(54) Schaltungsanordnung für die Vertikalablenkschaltung von Elektronenstrahlen in einer Fernsehbildröhre.

(30) Priorität: 23.06.83 DE 3322602

(43) Veröffentlichungstag der Anmeldung:
02.01.85 Patentblatt 85/1

(45) Bekanntmachung des Hinweises auf die Patenterteilung:
07.01.87 Patentblatt 87/2

(84) Benannte Vertragsstaaten:
AT BE CH FR GB IT LI LU NL SE

(56) Entgegenhaltungen:
EP - A - 0 008 263
FR - A - 2 410 402

(73) Patentinhaber: **Deutsche Thomson-Brandt GmbH, Hermann-Schwer-Strasse 3 Postfach 2060, D-7730 Villingen-Schwenningen (DE)**

(72) Erfinder: **Hartmann, Uwe, Tallardstrasse 15, D-7730 Villingen-Schwenningen (DE)**
Erfinder: **Mai, Udo, Mühleschweg 2, D-7730 VS-Tannheim (DE)**

## Beschreibung

Die Erfindung geht aus von einer Schaltungsanordnung für die Vertikalablenkung von Elektronenstrahlen in einer Fernsehbildröhre, gemäss dem Oberbegriff des Anspruchs 1.

Eine derartige Schaltung ist in der EP-Anmeldung 000 8263 beschrieben worden. Diese Schaltung besitzt grosse Vorteile gegenüber den bis dahin bekannt gewordenen Schaltungsanordnungen zur Vertikalablenkung der Elektronenstrahlen in einer Fernsehbildröhre, die z.B. in ihrem guten Wirkungsgrad und in ihrer grossen Betriebssicherheit zum Ausdruck kommen. Die genannte Schaltungsanordnung besitzt jedoch einen Nachteil dadurch, dass am Integrationskondensator eine zeilenfrequente Störspannung steht, die Ursache für Geometrieverzerrungen des Bildes ist. Nun kann es vorkommen, dass die immer vorhandenen Toleranzen der Bildröhre den Geometriefehler derart vergrössern, dass dieser als störend empfunden wird. Der Fehler zeigt sich derart, dass ein wiedergegebenes Raster auf dem Bildschirm einen Winkelfehler besitzt, der vom oberen zum unteren Bildrand zunimmt. Die Abweichungen einer waagrechten Linie können vom linken Bildrand zum rechten Bildrand im oberen Bildteil bis zu 1 mm betragen und sich bis zum unteren Bildteil bis zu 4 mm vergrössern. Dieser Fehler wird hervorgerufen durch die zeilenfrequente Restspannung am Integrationskondensator, die einen entsprechenden zeilenfrequenten Strom durch die Vertikalablenkwicklung hervorruft. Dieser Fehler könnte durch Vergrösserung des Integrationskondensators vermindert werden, jedoch scheidet diese Lösung aus, da durch das Vorhandensein mehrerer phasendrehender Komponenten in der Ausgangsstufe der Ablenkschaltung, wie Integrationsspule, Integrationskondensator und die Vertikalablenkspule die Stabilität der Schaltung leiden würde, weil die Schleifenverstärkung mit ansteigender Phasendrehung verkleinert werden muss. Ausserdem steht ein zu grosser Integrationskondensator der geforderten Vertikalrücklaufzeit von kleiner als 1 ms entgegen.

*Aufgabe und Lösung*

Der Erfindung liegt die Aufgabe zugrunde, eine Lösung zur Beseitigung der geschilderten Geometriefehler anzugeben, die keine Nachteile für das angegebene Schaltungskonzept bietet. Diese Aufgabe wird bei einer Schaltungsanordnung der eingangs genannten Art gemäss dem kennzeichnenden Teil des Anspruchs 1 gelöst.

Nachstehend soll an einem Ausführungsbeispiel das Wesentliche der Erfindung mit Hilfe der Zeichnung erläutert werden.

Fig. 1 zeigt das Wesentliche der Vertikalablenkschaltung

Fig. 2 und Fig. 3 zeigen die an den eingezeichneten Schaltungspunkten des Blockschaltbildes entstehenden Signale

Fig. 4 zeigt eine weitere Schaltungsvariante.

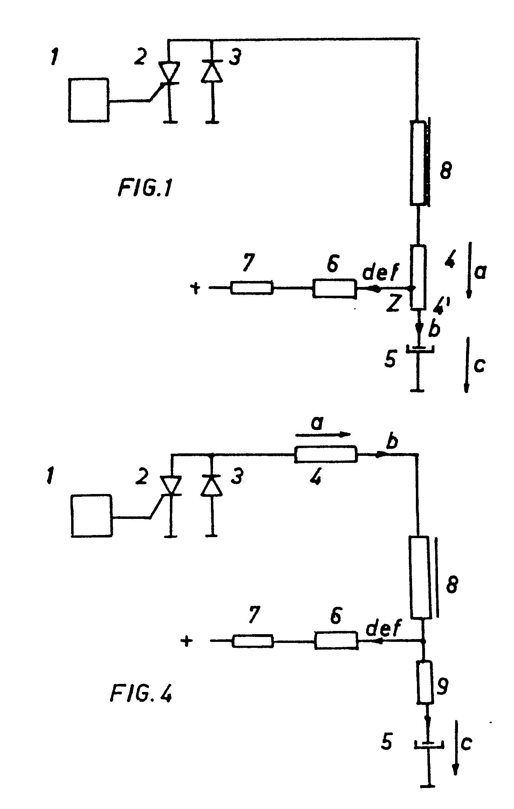

In Fig. 1 werden in einer Steuerschaltung 1 zeilenfrequente in ihrer Breite vertikalfrequent modulierte Impulse erzeugt, die an die Gate-Elektrode eines Thyristors 2 gelegt sind, dem eine Diode 3 antiparallel geschaltet ist. In Reihe zu dieser Kombination 2 und 3 ist eine Integrationsspule 4 gelegt, die in Verbindung mit einem Integrationskondensator 5 die zeilenfrequenten Impulse zu einem vertikalfrequenten Sägezahnstrom integriert, der durch die Vertikalablenkspule 6 mit in Serie zu dieser geschalteten Messwiderstand 7 fliesst, der mit seinem anderen Ende auf ein Bezugspotential liegt. In Serie zu der Integrationsspule 4 und dem Integrationskondensator 5 liegt die Wicklung 8 des Zeilentransformators des Fernsehempfangsgerätes.

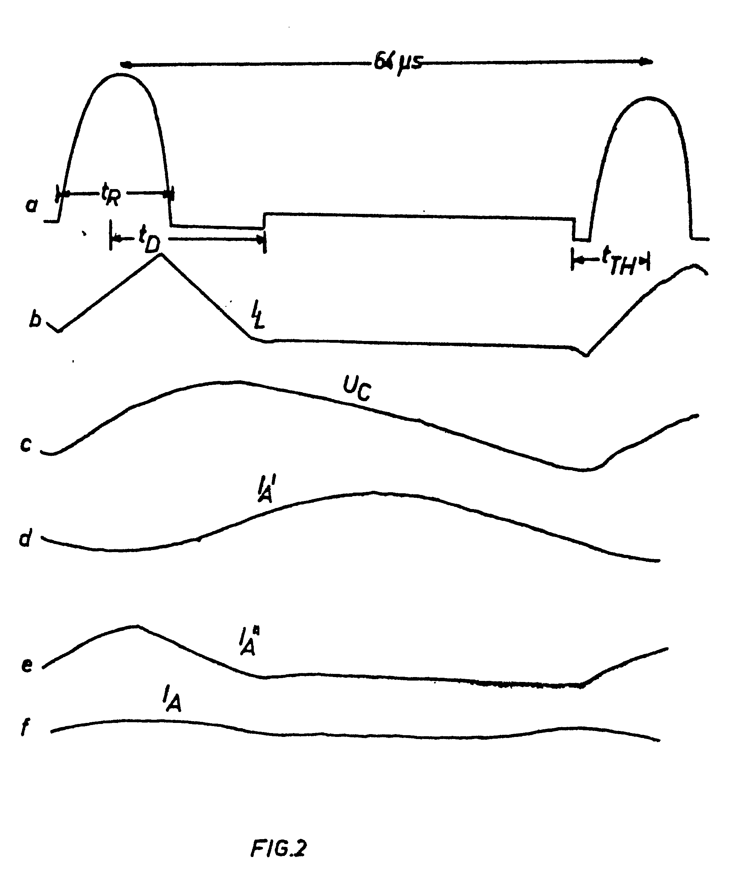

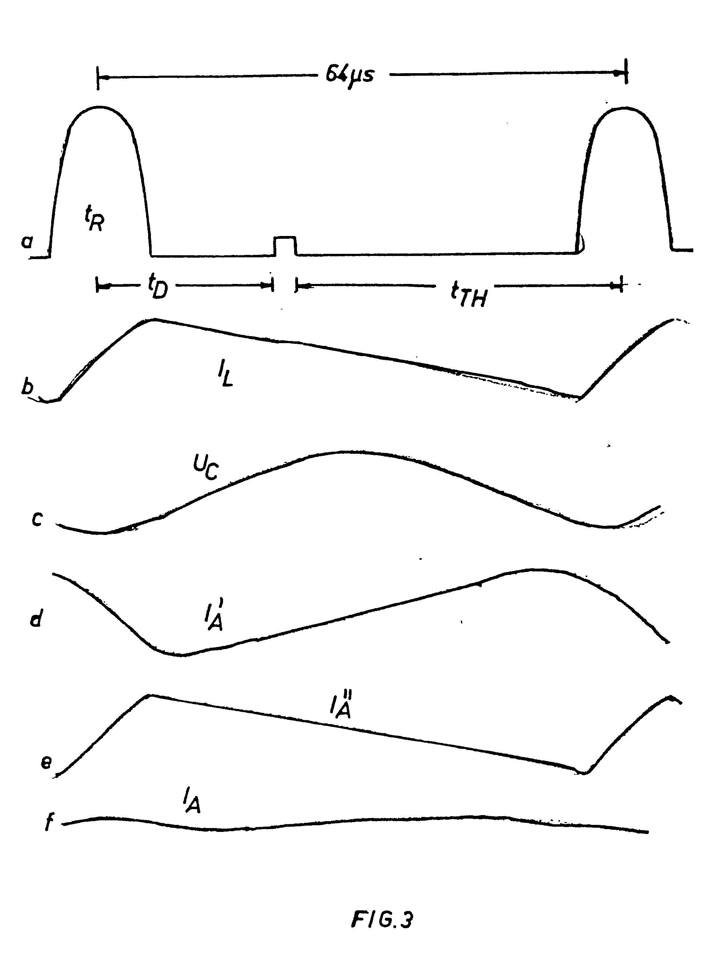

In Fig. 2 sind Spannungen und Ströme aufgetragen, wie sie am Bildanfang auftreten. Fig. 2a zeigt den zeilenfrequenten Spannungsverlauf $U_L$ an der Integrationsspule 4. Nach dem Zeilenrücklauf TR ist die Diode 3 in Durchlassrichtung während der Zeit TD leitend. Der Thyristor 2 ist in der darauffolgenden Zeit gesperrt. Die Öffnungsdauer des Thyristors 2 wird während der Vertikalablenkdauer kontinuierlich vergrössert, so dass er am unteren Bildrand sehr lange durchgeschaltet ist, wie in Fig. 3a gezeigt. Die Spannung UL erzeugt einen zeilenfrequenten Strom IL durch die Integrationsspule 4, der ungefähr gleich dem Ladestrom IC für den Integrationskondensator 5 ist. (Fig. 2b, Fig. 3b). Dieser Strom ruft am Kondensator 5 eine parabelförmige Spannung nach Fig. 2c, Fig. 3c hervor. Ohne die Massnahme der Erfindung würde diese Spannung einen zusätzlichen Ablenkstrom $I_A'$ durch die Ablenkspule 6 hervorrufen, wie Fig. 2d und Fig. 3d zeigt. Dieser zeilenfrequente Störstrom ruft die eingangs geschilderten Geometrieverzerrungen hervor. Durch Einfügen einer induktiven Imponente kann dieser Störstrom kompensiert werden. An einer Teilinduktivität 4' der Integrationsspule 4 entsteht eine rechteckförmige zeilenfrequente Teilspannung, die einen kompensierenden Ablenkstrom $I_A''$ gemäss Fig. 2e, Fig. 3e durch die Vertikalablenkspule 6 hervorruft. Es ergibt sich ein Gesamtablenkstrom $I_A$ gemäss Fig. 2f und Fig. 3f.

Während in Fig. 1 die induktive Komponente 4' durch einen Abgriff Z an der Integrationsspule 4 gebildet wird, ist in Fig. 4 eine weitere Schaltungsvariante für den Fall gezeigt, dass die Integrationsspule 4 zwischen der Thyristor-Dioden-Kombination 2 und 3 und der Zeilentransformatorwicklung 8 liegt. In diesem Fall wird eine entsprechend dimensionierte Zusatzinduktivität 9 in Serie zur Integrationskondensator 5 geschaltet.

## Patentansprüche

1. Schaltungsanordnung für die Vertikalablenkung von Elektronenstrahlen in einer Fernsehbildröhre, bei der der Ablenkstrom durch Ansteuerung mit zeilenfrequent impulsbreiten-modulierten Signalen eines bipolaren Schalters (2, 3) gewonnen wird, dessen einer Kontakt unmittelbar auf Bezugspotential liegt und dessen anderer Kontakt über eine Serienschaltung bestehend aus einer Wicklung (8) des Zeilentransformators, aus einer Integrationsspule (4) und aus einem Integrations-Kondensator (5), auf Bezugspotential geschaltet ist, wobei der eine Anschluss der Ablenkwicklung (6) der Fernsehbildröhre über einen Messwiderstand (7) an einer positiven Versorgungsspannung (+) liegt, dadurch gekennzeichnet, dass in Serie zum Integrations-Kondensator (5) eine induktive Komponente (4', 9) geschaltet ist und dass der andere Anschluss der Ablenkwicklung (6) der Fernsehbildröhre über die Serienschaltung aus der induktiven Komponente (4', 9) und dem Integrations-Kondensator (5) auf das Bezugspotential geschaltet ist, wobei die induktive Komponente derart bemessen ist, dass sie den durch die zeilenfrequente Restspannung am Integrations-Kondensator (5) entstehenden Strom durch die Ablenkwicklung (6) mindestens kompensiert.

2. Schaltungsanordnung nach Anspruch 1, dadurch gekennzeichnet, dass die induktive Komponente durch einen Teil (4') der Integrations-Spule (4) gebildet wird und dass der andere Anschluss der Ablenkwicklung (6) der Fernsehbildröhre mit einer Anzapfung (z) der Integrations-Spule (4) verbunden ist.

## Claims

1. A circuit arrangement for the vertical deflection of electron beams in a television picture tube, wherein the deflection current is obtained by actuating, with line-frequency, pulse-width-modulated signals, a bipolar switch (2, 3), one contact of which is directly at reference potential and the other contact of which is connected to reference potential through a series connection consisting of a winding (8) of the line transformer, of an integrating coil (4) and of an integrating capacitor (5), one connection of the deflection winding (6) of the television picture tube being connected to a positive supply voltage (+) through a precision resistor (7), characterised in that an inductive component (4', 9) is connected in series with the integrating capacitor (5) and that the other connection of the deflection winding (6) of the television picture tube is connected to the reference potential through the series connection of the inductive component (4', 9) and the integrating capacitor (5), the inductive component being so dimensioned that it at least compensates the current through the deflection winding (6) resulting from the line-frequency residual voltage at the integrating capacitor (5).

2. A circuit arrangement as claimed in claim 1, characterised in that the inductive component is formed by a part (4') of the integrating coil (4) and that the other connection of the deflection winding (6) of the television picture tube is connected to a tap (Z) of the integrating coil (4).

## Revendications

1. Circuit de déviation verticale de faisceaux électroniques dans un tube-image de télévision, dans lequel le courant de déviation est obtenu par commande d'un commutateur bipolaire (2, 3) avec des signaux modulés en largeur d'impulsions à la fréquence de lignes et dont un contact est soumis directement à un potentiel de référence tandis que son autre contact est soumis au potentiel de référence par l'intermédiaire d'un circuit-série se composant d'un enroulement (8) du transformateur de lignes, d'une bobine d'intégration (4) et d'un condensateur d'intégration (5), l'une des bornes de l'enroulement de déviation (6) du tube-image de télévision étant soumise par l'intermédiaire d'une résistance de mesure (7) à une tension positive d'alimentation (+), caractérisé en ce qu'il est prévu en série avec le condensateur d'intégration (5) une composante inductive (4', 9) et en ce que l'autre borne de l'enroulement de déviation (6) du tube-image de télévision est soumise, par l'intermédiaire du circuit-série comprenant la composante inductive (4', 9) et le condensateur d'intégration (5), au potentiel de référence, la composante inductive étant dimensionnée de telle sorte qu'elle compense au moins le courant passant dans l'enroulement de déviation (6') et engendré par la tension résiduelle, à la fréquence de lignes, dans le condensateur d'intégration (5).

2. Circuit selon la revendication 1, caractérisé en ce que la composante inductive est constituée par une partie (4') de la bobine d'intégration (4) et en ce que l'autre borne de l'enroulement de déviation (6) du tube-image de télévision est reliée à une prise (Z) de la bobine d'intégration (4).

FIG.1

FIG.4

FIG.2

FIG.3